# EUROPEAN PATENT APPLICATION

(11) **EP 4 750 273 A1**
(43) Date of publication of application: **27.05.2026**
(21) Application number: 25174325.8
(22) Date of filing: 05.05.2025
(51) Int. Cl.: H10F 71/00, H10F 77/30

(54) **PHOTOVOLTAIC CELL PREPARATION METHOD AND PHOTOVOLTAIC CELL**

(30) Priority: 21.11.2024 CN 202411677721
(71) Applicant: Jinko Solar (Shangrao) Co., Ltd, Shangrao, Zhejiang (CN); Zhejiang Jinko Solar Co., Ltd., Haining, Zhejiang 314416 (CN)
(72) Inventor: ZENG, Xianhuan, SHANGRAO (CN); WANG, Yilan, SHANGRAO (CN); LI, Chao, SHANGRAO (CN); ZHANG, Ning, SHANGRAO (CN)
(74) Representative: DREISS Patentanwälte PartG mbB

(57) **Abstract**

The present disclosure relates to a photovoltaic cell preparation method, and a photovoltaic cell. The method includes: preparing a substrate including a first surface and a second surface opposite to each other, wherein the first surface is a textured structure; placing the substrate into an ALD deposition chamber; sequentially depositing an aluminum-silicon layer and an alumina layer on the first surface; placing the substrate having the aluminum-silicon layer and the alumina layer into a PECVD deposition chamber; depositing a silicon nitride layer on the alumina layer; feeding ammonia gas into the PECVD deposition chamber, and turning on a radio frequency power supply to ionize hydrogen ions from the ammonia gas; and diffusing the hydrogen ions into the aluminum-silicon layer. The aluminum-silicon layer forms an aluminum-silicon bond on the first surface of the substrate, hydrogen ions are diffused to the aluminum-silicon layer to form an aluminum-hydrogen bond. When ultraviolet light is irradiated to the surface of the photovoltaic cell, the aluminum-hydrogen bond can reduce the possibility of damage caused by ultraviolet light to the silicon-hydrogen bond on the surface of the silicon layer, so that the chemical passivation loss of the photovoltaic cell is reduced, thereby improving the conversion efficiency.

## Description

### TECHNICAL FIELD

The present disclosure relates to a technical field of solar power generation, and in particular, to a photovoltaic cell preparation method and a photovoltaic cell.

### BACKGROUND

Photovoltaic cells convert the absorbed sunlight into electricity through photoelectric effect. With long-term use of photovoltaic cells, photovoltaic cells are prone to decay under ultraviolet light, resulting in the decline of electrical performance of photovoltaic cells and the decline of photoelectric conversion efficiency, which will affect the overall power generation capacity of photovoltaic cells.

### SUMMARY

In view of this, the present disclosure provides a photovoltaic cell preparation method and a photovoltaic cell to solve a problem that photovoltaic cells are prone to decay under ultraviolet light.

In first aspect, the present disclosure provides a photovoltaic cell preparation method. The preparation method includes:
preparing a substrate including a first surface and a second surface opposite to each other, wherein the first surface is a textured structure;
placing the substrate into an ALD deposition chamber;
sequentially depositing an aluminum-silicon layer and an alumina layer on the first surface;
placing the substrate having the aluminum-silicon layer and the alumina layer into a PECVD deposition chamber;
depositing a silicon nitride layer on the alumina layer;
feeding ammonia gas into the PECVD deposition chamber, and turning on a radio frequency power supply to ionize hydrogen ions from the ammonia gas; and
diffusing the hydrogen ions into the aluminum-silicon layer.

In some embodiments, when the aluminum-silicon layer and the alumina layer are sequentially deposited on the first surface, the method includes:
firstly feeding 18 sccm to 22 sccm of water vapor into the ALD chamber for 4s to 6s, and then feeding nitrogen gas to purge for 10s to 14s, and cycling for 3 times to 7 times;
firstly feeding 16 sccm to 20 sccm of TMA into the ALD chamber for 7s to 9s; then feeding nitrogen gas to purge for 10s to 14s; then feeding 20sccm to 24sccm of water vapor for 4s to 6s; and finally feeding nitrogen gas to purge for 10s to 14s, and cycling for 7 times to 12 times, in order to deposit the aluminum-silicon layer.

In some embodiments, before placing the substrate into the ALD deposition chamber, the method includes:
the first surface of the substrate including a first region and a second region, the first region configured to be provided with an electrode line, coating a separating layer in the first region, and curing.

In some embodiments, after placing the substrate having the aluminum-silicon layer and the alumina layer into a PECVD deposition chamber, the method includes:
increasing the temperature within the PECVD chamber to 460°C to 550°C for 15min to 25min.

In some embodiments, when feeding ammonia gas into the PECVD deposition chamber, and turning on a radio frequency power supply to ionize hydrogen ions from the ammonia gas, the method includes:
feeding 8000sccm to 11000sccm of ammonia and 3000sccm to 6000sccm of nitrous oxide into the PECVD chamber with a RF power of 15000KW to 18000KW.

In some embodiments, when diffusing the hydrogen ions into the aluminum-silicon layer, the method includes:
increasing temperature within the PECVD chamber to 500°C to 600°C; and
depositing a silicon nitride layer and a silicon oxide layer.

In some embodiments, when feeding ammonia gas into the PECVD deposition chamber, and turning on a radio frequency power supply to ionize hydrogen ions from the ammonia gas, the method includes:
cooling the PECVD chamber to 300°C to 400°C, feeding ammonia gas with a flow rate of 8000 sccm to 15000 sccm, and RF power of 10,000 KW to 18,000 KW to produce free hydrogen ions.

In some embodiments, when diffusing the hydrogen ions into the aluminum-silicon layer, the method includes:
turning on an infrared lamp in the PECVD chamber to irradiating for 5min to 10min.

In a second aspect, the present disclosure provides a photovoltaic cell. The photovoltaic cell includes:
a substrate including a first surface and a second surface opposite to each other, wherein the first surface being provided with a boron doping layer, and by the photovoltaic cell preparation method as claimed in any one of claims 1 to 8, the boron doping layer is arranged with an aluminum-silicon layer, an alumina layer, and a silicon nitride layer on a surface of the boron doping layer in sequence.

In some embodiments, a thickness of the aluminum-silicon layer ranges from 0.5 nm to 1 nm.

The present disclosure relates to a photovoltaic cell preparation method, and a photovoltaic cell. The method includes: preparing a substrate including a first surface and a second surface opposite to each other, wherein the first surface is a textured structure; placing the substrate into an ALD deposition chamber; sequentially depositing an aluminum-silicon layer and an alumina layer on the first surface; placing the substrate having the aluminum-silicon layer and the alumina layer into a PECVD deposition chamber; depositing a silicon nitride layer on the alumina layer; feeding ammonia gas into the PECVD deposition chamber, and turning on a radio frequency power supply to ionize hydrogen ions from the ammonia gas; and diffusing the hydrogen ions into the aluminum-silicon layer. The aluminum-silicon layer forms an aluminum-silicon bond on the first surface of the substrate, hydrogen ions are diffused to the aluminum-silicon layer to form an aluminum-hydrogen bond. When ultraviolet light is irradiated to the surface of the photovoltaic cell, the aluminum-hydrogen bond can reduce the possibility of damage caused by ultraviolet light to the silicon-hydrogen bond on the surface of the silicon layer, so that the chemical passivation loss of the photovoltaic cell is reduced, thereby improving the conversion efficiency.

### BRIEF DESCRIPTION OF DRAWINGS

In order to more clearly explain the embodiments of the present disclosure or the technical solution in the related art, the drawings to be used in the description of the embodiments or the related art will be briefly described below. The drawings in the following description are some embodiments of the present disclosure. For those skilled in the art, other drawings may also be obtained based on these drawings.
FIG. 1 is a structural diagram of a substrate according to some embodiments of the present disclosure;
FIG. 2 is a structural diagram of the aluminum-silicon layer deposited on the substrate according to some embodiments of the present disclosure;
FIG. 3 is a structural diagram of aluminum-silicon layer and alumina layer deposited on the substrate according to some embodiments of the present disclosure;
FIG. 4 is a structural diagram of a separating layer coated on the substrate according to some embodiments of the present disclosure;
FIG. 5 is a structural diagram of deposited aluminum-silicon layer and alumina layer on the basis of FIG. 4.
FIG. 6 is a structural diagram of aluminum-silicon layer, alumina layer, silicon nitride, silicon nitride and silicon oxide layers deposited on the substrate according to some embodiments of the present disclosure;
FIG. 7 is a structural diagram of a photovoltaic cell according to some embodiments of the present disclosure; and
FIG. 8 is a structural diagram of a photovoltaic cell according to some embodiments of the present disclosure.

### Reference signs:

1- substrate;
   11- silicon wafer;
   12- boron doping layer;
   13-BSG layer;
   14- Tunnel oxide layer;
   15-poly layer;
   16-phosphorus doping layer;
   17-PSG layer;
2- aluminum-silicon layer;
3-alumina layer;
4- separating layer;
5-silicon nitride layer;
6-silicon oxynitride layer;
7-silicon oxide layer;
8- passivation layer; and
9- electrode line.

### DESCRIPTION OF EMBODIMENTS

In order to better understand technical solutions of the present disclosure, the embodiments of the present disclosure are described in details with reference to the drawings.

It should be clear that the described embodiments are merely part of the embodiments of the present disclosure rather than all of the embodiments. All other embodiments obtained by those skilled in the art without paying creative labor shall fall into the protection scope of the present disclosure.

The terms used in the embodiments of the present disclosure are merely for the purpose of describing specific embodiment, rather than limiting the present disclosure. The terms "a", "an", "the" and "said" in a singular form in the embodiments of the present disclosure and the attached claims are also intended to include plural forms thereof, unless noted otherwise.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

Photovoltaic cell through the photoelectric effect, the absorbed sunlight is converted into electric power. In the process of sunlight absorption of the photovoltaic cell, there will be ultraviolet radiation to the surface of photovoltaic cell, the first surface of the substrate 1 has silicon-hydrogen bond, ultraviolet light in the sunlight after irradiation of the substrate 1 will break silicon-hydrogen bond, resulting excess hydrogen atoms in the first surface, promoting carrier recombination, thereby affecting power generation efficiency of the photovoltaic cell.

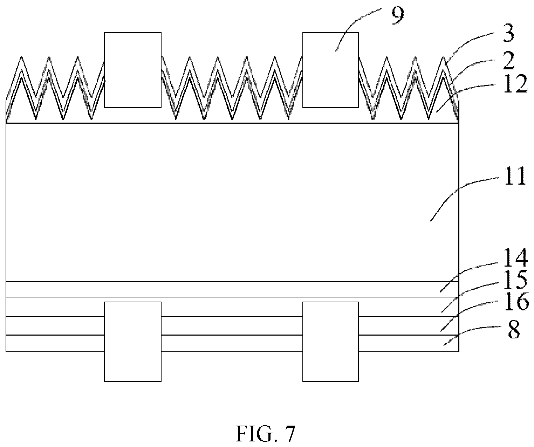

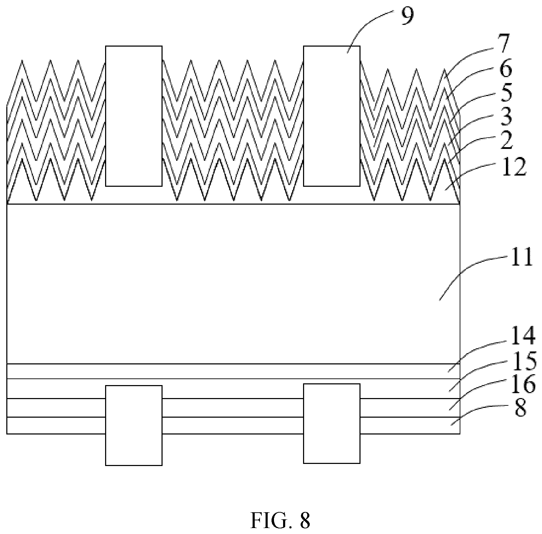

As shown in FIG. 7 and FIG. 8, the embodiments of the present disclosure provides a photovoltaic cell. The photovoltaic cell includes a substrate 1 that includes a first surface and a second surface opposite to each other. The first surface is arranged with a boron doping layer 12, and the surface of the boron doping layer 12 is sequentially arranged by an aluminum-silicon layer 2, an alumina layer 3 and a silicon nitride layer 5.

Aluminum-silicon layer 2 can form an aluminum-silicon bond on the first surface of the substrate 1. During the preparation process of the photovoltaic cell, some hydrogen ions will diffuse to the aluminum-silicon layer 2 to form an aluminum-hydrogen bond. The aluminum-hydrogen bond is located in the upper layer of the silica-hydrogen bond. When ultraviolet light is irradiated to the surface of the photovoltaic cell, the aluminum-hydrogen bond reduces the possibility of breakage to the silica-hydrogen bond caused by ultraviolet light, and reduces the chemical passivation loss of the photovoltaic cell, thereby improving the conversion efficiency of the photovoltaic cell. The alumina layer 3 and silicon nitride layer 5 improve the passivation effect of photovoltaic cells. Compared with the photovoltaic cells in the related art, the conversion efficiency of the photovoltaic cell provided by the embodiments of the present disclosure increases by 0.03% to 0.05%, and the reliability increases by about 50%.

In the present disclosure, by arranging the aluminum-silicon layer 2 on the surface of the silicon wafer 11 to form an aluminum-hydrogen bond after hydrogen injection, so as to reduce the chemical passivation loss caused by ultraviolet light to photovoltaic modules. There is no limit on the types of photovoltaic cells in this solution. The types of photovoltaic cells can be Passivated Emitter Rear Cell (PERC), and Tunnel Oxide Passivated Contact (TOPCon), etc.

For the PERC cell, along its thickness direction, the PERC cell sequentially includes a front surface metal silver electrode, a front surface silicon nitride passivation layer, a phosphorus layer emitter, a P-type substrate silicon layer, a local aluminum back field, a metal aluminum back electrode, a back passivation layer (Al₂O₃/SiNx). The PERC cell adopts a passivation film to passivate the back side, the all-aluminum back field is replaced, the internal back reflection of light is enhanced in the silicon base, thereby reducing the recombination rate of the back side, and improving the efficiency of the cell by 0.5%-1%.

For the TOPCon cells, along its thickness direction, TOPCon cells sequentially includes a silver metal electrode, a front surface silicon nitride passivation layer, a boron-doping emitter, an N-type substrate silicon layer, a diffused doping layer, an ultra-thin silicon oxide, doping polysilicon, silicon nitride, and a silver metal electrode. The back of the cell is composed of a layer of ultra-thin silicon oxide (1nm~2nm) and a layer of phosphate-doping microcrystalline amorphous mixed Si film which together form a passivated contact structure. Such a structure can prevent recombination of minority hole and increase the open circuit voltage and short circuit current of the cell. The ultra-thin oxide layer can tunnel majority electron into the polysilicon layer and prevent recombination of minority hole. The good passivation effect of ultra-thin silicon oxide and heavily doping silicon film makes the energy band on the surface of the silicon wafer bend, thus forming a field passivation effect. The probability of electron tunneling is greatly increased, the contact resistance is reduced, and the open circuit voltage and short circuit current of the cell are improved, thus improving the conversion efficiency of the cell.

The above two types of photovoltaic cells can be Multi-Busbar (MBB) cell (MBB) or no-Busbar cells (0BB).

For the multi-busbar cell, the surface of the cell is arranged with multiple busbars for collecting current, which shortens a conduction path of the current in the multi-busbar cell, reduces the internal loss, and then increases the power of the multi-busbar cell. With the increase of the number of busbar, the cross-sectional area of the busbar and the solder strip is reduced, and the adhesive film layer is thin, which can reduce the production cost of photovoltaic modules. With the increase of the busbar, the number of fingers can be reduced accordingly, which can reduce the production cost of the cell.

For the non-busbar cell, there is no busbar on the surface of the cell, and after multiple cells are soldered, the welding strip is directly connected to the finger instead of the original busbar, which can reduce the consumption of silver paste and reduce the production cost of the cell. The non-busbar cell can reduce the shading area of the electrode line 9 in the cell, and reduce the transmission loss of the finger, and increase the total power of the components. Meanwhile, the increase of finger contact points reduces the risk of hidden cracks in thin silicon wafer 11 and improves the yield and reliability.

As shown in FIG. 7 and FIG. 8, in some embodiments, the second surface of the substrate 1 includes a tunnel oxide layer 14, a poly layer 15 and a phosphorous doping layer 16. A passivation layer 8 can be provided on the phosphorous doping layer 16.

The bond of the tunnel oxide layer 14 with the phosphorus doping layer 16 can tunnel multiple electrons into the poly layer 15, while blocking the recombination of minority holes, and then electrons transmit transversely in the poly layer 15 and are collected by metal, which greatly reduces the recombination rate and increases the open circuit voltage and short circuit current of the cell, thereby improving conversion efficiency of the cell. The silicon nitride layer 5 and the poly layer 15 collectively form a passivation contact structure. By using quantum tunneling effect, multiple electron are allowed to tunnel and block the passage of minority holes, thereby reducing the recombination. The silicon nitride layer 5 can further reduce recombination rate of electrons and holes on the surface, further reduce the efficiency loss caused by surface recombination, thereby improving the overall efficiency of the photovoltaic cell.

In some embodiments, the thickness of the aluminum-silicon layer 2 is 0.5nm to 1nm.

The aluminum-silicon layer 2 is used to form the aluminum-silicon layer 2 on the first surface of the substrate 1, which in turn bonds with hydrogen ions to form aluminum-hydrogen bonds to reduce the chemical loss caused by ultraviolet light to the photovoltaic cell. If the thickness of the aluminum-silicon layer 2 is smaller than 0.5nm, the density of aluminum-silicon layer 2 on the first surface of the substrate 1 is poor, and the silicon surface of the first surface cannot be completely covered, resulting in poor anti-ultraviolet damage effect of the photovoltaic cell as a whole. If the thickness of aluminum-silicon layer 2 is greater than 1nm, it will reduce the contact between the metal electrode and the boron doping layer 12, and may also cause the sunlight to be difficult to reach the boron doping layer 12, thus affecting the power generation efficiency of the photovoltaic cell. Therefore, the thickness of the aluminum-silicon layer 2 can be 0.5nm, 0.7nm, or 1nm, etc., which improves the coverage of the silicon surface of the first surface of the substrate 1 covered by the aluminum-silicon layer 2, and improves the anti-ultraviolet damage effect of the photovoltaic cell.

Compared with the conventional structure in which only the aluminum oxide layer 3 is arranged on the silicon layer of the first surface of the substrate 1, when the ultraviolet intensity is UV15, the attenuation rate of the photovoltaic cell is 0.87%; when the ultraviolet intensity is UV30, the attenuation rate of the photovoltaic cell is 0.70%; and when the ultraviolet intensity is UV60, the attenuation rate of the photovoltaic cell is 2.33%. In the embodiments of the present disclosure, the aluminum-silicon layer is provided between the alumina layer 3 and the silicon layer, which forms aluminum-hydrogen bonds after hydrogen injection. When the ultraviolet intensity is UV15, the attenuation rate of the photovoltaic cell is 0.48%; when the ultraviolet intensity is UV30, the attenuation rate of the photovoltaic cell is 0.67%; and when the ultraviolet intensity is UV60, the attenuation rate of the photovoltaic cell is 1.22%. Therefore, the photovoltaic cells provided by the embodiments of the present disclosure have a low attenuation rate under ultraviolet irradiation.

Compared with the solution without arranging the aluminum-silicon layer 2, the front attenuation rate of photovoltaic cells is 1.81% under UV irradiation of UV30, the front attenuation rate of photovoltaic cells is 2.27% under UV irradiation of UV60. The photovoltaic cells provided by the embodiments of the present disclosure has a front attenuation rate of 1.22% under UV irradiation of UV30, and a front attenuation rate of 1.25% under UV irradiation of UV60. Therefore, the front attenuation rate of the photovoltaic cell provided by the embodiments of the present disclosure is lower under ultraviolet light with different intensities. Through EL image detection of photovoltaic cells attenuated by ultraviolet irradiation, the EL image of photovoltaic cells provided by the embodiments of the present disclosure has higher overall brightness and less damage degree.

Compared with the photovoltaic cells without the aluminum-silicon layer 2, the photovoltaic cells provided by the embodiments of the present disclosure have better electrical property, the open circuit voltage is increased by 0.2mV to 0.3mV, the fill factor is increased by 0.04% to 0.11%, and the conversion efficiency is increased by about 0.02%.

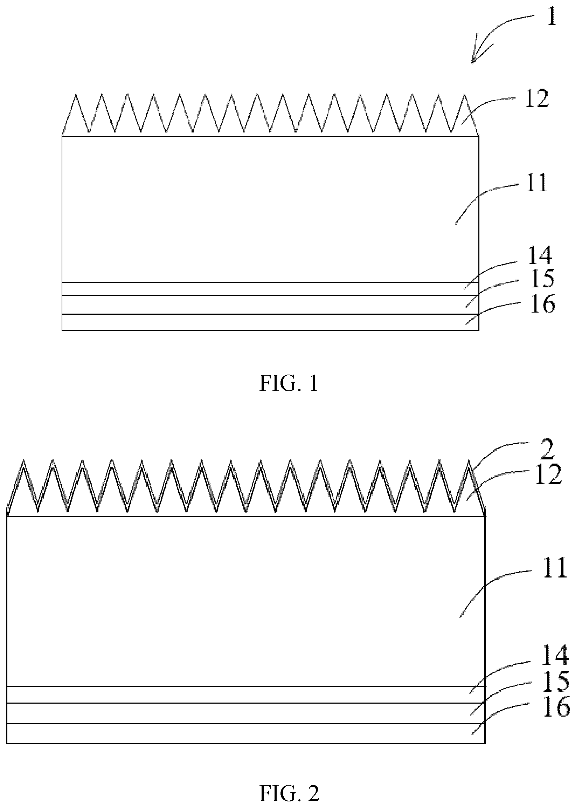

As shown in FIG. 1 to FIG. 6, the embodiments of the present disclosure provides a photovoltaic cell preparation method. The method includes:
S1, preparing a substrate 1 including a first surface and a second surface opposite to each other, wherein the first surface is a textured structure;
S2, placing the substrate 1 into an ALD deposition chamber;
S3, sequentially depositing an aluminum-silicon layer 2 and an alumina layer 3 on the first surface;
S4, placing the substrate 1 having the aluminum-silicon layer 2 and the alumina layer 3 into a PECVD deposition chamber;
S5, depositing a silicon nitride layer 5 on the alumina layer 3;
S6, feeding ammonia gas into the PECVD deposition chamber, and turning on a radio frequency power supply to ionize hydrogen ions from the ammonia gas; and
S7, diffusing the hydrogen ions into the aluminum-silicon layer 2.

Deposition of aluminum-silicon layer 2 on the upper surface of the substrate 1 can form aluminum-silicon bond on the first surface, reduce the interface defect density of the first surface, and diffuse ionized hydrogen ions to aluminum-silicon layer 2, so that free hydrogen ions are bonded with the aluminum-silicon layer 2 and alumina interface defect. Due to the ionic property, aluminum-silicon bond will form positive and negative charge centers through electron transfer. Under the stimulation of the external environment, free electron-hole pairs will be generated to form aluminum hydrogen bonds, the hydrogen silicon bonds in the related art are replaced, which can reduce the chemical passivation loss and improve the efficiency of photovoltaic cells.

As shown in FIG. 1, in some embodiments, the first surface of the substrate 1 is textured, and the second surface is sequentially arranged with a tunnel oxide layer 14, a poly layer 15, and a phosphorus doping layer 16, respectively. The steps for preparing the substrate 1 are as follows:
S11, preparing a silicon wafer 11 to texture the silicon wafer 11 on both sides;
S12, boron diffusion is carried out on the textured silicon wafer 11 to form a boron doping layer 12, and a PN junction is formed on the surface of silicon wafer 11;
S13, removing in a chain manner the BSG layer 13 on the second surface of silicon wafer 11, and then alkali polishing, polishing the second surface of the silicon wafer 11, and finally removing in a chain manner the BSG layer 13 on the first surface of the silicon wafer 11;
S14, using the LPCVD double insertion method, sequentially deposit the tunnel oxide layer 14 and poly layer 15 on the second surface of the silicon wafer 11;
S15, phosphorus doping and annealing the second surface of the silicon wafer 11 by means of double insertion to form phosphorus doping layer 16; and
S16, removing in a chain manner PSG on the second surface of the silicon wafer 11 and wrap-plating on the first surface.

Double-sided texturing the silicon wafer 11 can improve the light absorption efficiency of the silicon wafer 11, and form PN junction through boron diffusion on the surface of the silicon wafer 11. When the sun shines on the PN junction, the internal electrons can be excited to generate current. After boron diffusion, BSG layer 13 is formed on the surface of the silicon wafer 11. After removing the BSG layer 13, the second surface of the silicon wafer 11 is polished to improve the passivation effect of the second surface of the silicon wafer 11 and the transport performance of carriers. The deposition of tunnel oxide layer 14 on the second surface can reduce the minority recombination rate, increase the open circuit voltage and short circuit current of the cell, thus improving the conversion efficiency of the cell. The poly layer 15 can perform surface passivation and charge carrier selection for the second surface to further optimize the performance of the cell. The second surface of phosphorus doping layer 16 can improve the photoelectric conversion efficiency, optimize the electrical performance of the substrate 1, and reduce the surface recombination and metal contact recombination. In the process of phosphorus diffusion, the PSG layer 17 is formed, and the removal of PSG layer 17 and the first surface coating facilitates the subsequent processing of the substrate 1.

In some embodiments, when the substrate 1 is placed in an ALD deposition chamber, the preparation method includes:
S21, placing the second surfaces in multiple substrates 1 opposite to one another on a first vehicle, and then placing them with the first vehicle into the ALD deposition chamber.

The second surfaces of the substrates 1 in the first vehicle are placed opposite to one another so that the first surface of the substrate 1 is exposed, enabling the first surface of the substrate 1 to deposit aluminum-silicon layer 2 and alumina layer 3 in the ALD deposition chamber.

In some embodiments, as shown in FIG. 2, when the aluminium-silicon layer 2 is deposited on a first surface, the preparation method includes:
S31, water vapor with a flow rate of 18sccm to 22sccm is firstly fed into the ALD chamber for a duration of 4s to 6s, and then nitrogen is injected to purge for 10s to 14s, and this cycle is repeated for 3 to 7 times.
S32, TMA is fed into the ALD deposition chamber, the flow rate of TMA is 16sccm to 20sccm, the duration is 7s to 9s; then, nitrogen gas was fed to purge for 10s to 14s; and then the water vapor is fed, the flow rate of water vapor is 20sccm to 24sccm, the duration is 4s to 6s; finally, nitrogen gas is fed to purge 10s to 14s, and this cycle is repeated for 8 to 12 times to deposit the aluminum-silicon layer 2.

The first surface of the substrate 1 is a textured structure. In the process for preparing the substrate 1, the concave position is prone to remaining impurities. In S31, the surface of the substrate 1 can be cleaned by alternating purging of water vapor and nitrogen gas, so that the impurities generated in the process for preparing the substrate 1 can be separated from the surface of the substrate 1 with the water vapor and/or nitrogen gas.

Then by depositing the aluminum-silicon layer 2 on the first surface of the substrate 1 in S32, TMA (trimethylaluminum) is fed to deposit aluminum bonds on the first surface, and form an aluminum-silicon bond with the silicon of the first surface. The flow rate of TMA is low, which can be 16sccm, 18sccm, or 20sccm, etc., and the duration is long, which can be 7s, 8s, or 9s, etc., so that more TMA is attached to the first surface, and then it is convenient to form aluminum-silicon bond with the silicon on the surface of the substrate 1, thereby forming the aluminum-silicon layer 2. After TMA deposition, nitrogen gas is fed to purge, so that the attachment of the TMA to the first surface is more uniform, and the TMA not attached to the first surface will be blown out of the ALD chamber by nitrogen gas to remove excess TMA. Water vapor will cause TMA on the surface to form thin alumina, so as to connect two TMA deposition, flow rate of water vapor is high, which can be 20sccm, 22sccm, or 24sccm, etc., the duration is short, which can be 4s, 5s, or 6s, etc., in order to improve the preparation efficiency of photovoltaic cells. Meanwhile, the possibility of TMA all being oxidized to alumina can be reduced, the content of aluminum bond in the aluminum silicon layer 2 is improved, so that aluminum bond can form aluminum silicon bond with the silicon surface of the matrix. After water vapor is fed and then nitrogen gas is fed to purge, the remaining water vapor is blown out of the ALD deposition chamber. Since the first surface of the substrate 1 is a textured structure, which is not convenient for TMA attachment, the above processes can be circulated for 8 times, 10 times, or 12 times, etc., so that a dense aluminum-silicon layer 2 of 0.5nm to 1nm can be formed on the textured structure of the first surface, thereby reducing the possibility of exposing the layers having silicon.

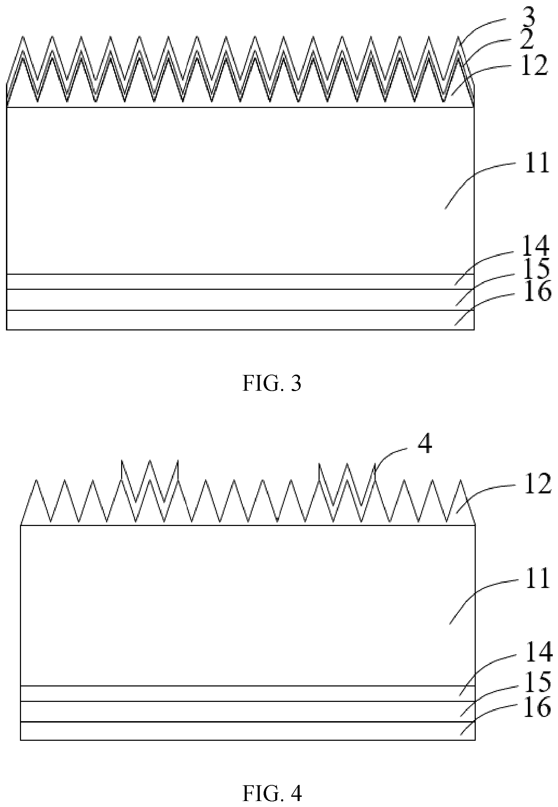

In some embodiments, as shown in FIG. 3, when the alumina layer 3 is deposited on the first surface, the preparation method includes:
S33, TMA with a flow rate of 18sccm to 22sccm is fed into the ALD chamber for a duration of 6s to 8s; then, nitrogen gas was fed to purge for 10s to 14s; then water vapor with a flow rate of 18sccm to 22sccm is fed for a duration of 6s to 8s, and finally nitrogen gas is fed to purge for 10s to 14s, and this cycle is repeated for 18 to 22 times.

When the alumina layer 3 is deposited, the flow rate of TMA can be 18sccm, 20sccm, or 22sccm, etc., and its duration can be 6s, 7s, or 8s, etc., so that TMA is deposited on the first surface; then nitrogen gas is fed to purge, which can improve the uniformity of TMA on the first surface while blowing out excess TMA; then the water vapor is fed, so that TMA is oxidized to be the alumina layer 3, the flow rate of water vapor can be 18sccm, 20sccm, or 22sccm, etc., the duration can be 6s, 7s, or 8s, etc., so that TMA can be fully oxidized to form the alumina layer 3; finally, the excess water vapor is blown out by nitrogen gas purging. The above process can be circulated for 18 times, 20 times, or 22 times, etc., and an alumina layer 3 with a thickness of 2nm to 4nm is formed by depositing on the aluminum-silicon layer 2 on the first surface, thereby improving the passivation effect of the first surface.

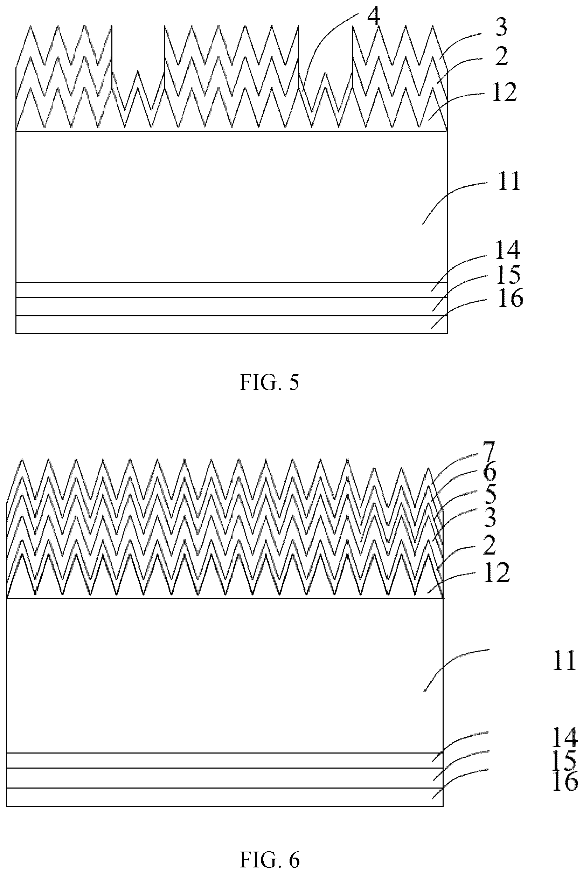

In some embodiments, as shown in FIG. 4 and FIG. 5, before placing the substrate 1 into the ALD deposition chamber, the preparation method includes:
S20, the first surface of the substrate 1 includes a first region and a second region, the first region is configured to arrange a electrode line 9, a separating layer 4 is coated in the first region, and cured.

The separating layer 4 can be a coating with high temperature resistance and hydrophobicity, such as polytetrafluoroethylene. When the substrate 1 is placed in the ALD chamber to deposit the aluminum-Si layer 2 and/or alumina layer 3, the first region coated with the separating layer 4 is less likely to attach TMA, thereby reducing the possibility of forming the aluminum-silicon layer 2 and the alumina layer 3 in the first region. In the subsequent arrangement of the electrode line 9 without etching the aluminum-silicon layer 2 and/or alumina layer 3 in the first region, so that the electrode line 9 is easy to contact the boron doping layer 12, thereby reducing the recombination loss at the position of the electrode line 9.

In some embodiments, before placing the substrate 1 having the aluminum-silicon layer 2 and the alumina layer 3 into a PECVD deposition chamber, the preparation method includes:
S41, placing the second surfaces of multiple substrates 1 opposite to one another on a second vehicle, and then placing them with the second vehicle into the PECVD deposition chamber.

The second surface of the substrate 1 is placed opposite to each other so that the first surface of the substrate 1 is exposed to the PECVD chamber and silicon nitride layer 5 can be deposited on the first surface.

In some embodiments, after placing the substrate 1 having the aluminum-silicon layer 2 and the alumina layer 3 into a PECVD deposition chamber, the preparation method includes:
S42, the temperature within the PECVD chamber is increased to 460 °C to 550 °C for a duration of 15min to 25min.

The temperature within the PECVD chamber can be increased to 460°C, 500°C, or 550°C, etc., which can provide deposition conditions for the silicon nitride layer 5. The decomposition temperature of polytetrafluoroethylene is 350°C, and the temperature of PECVD chamber is higher than the temperature of polytetrafluoroethylene, so that polytetrafluoroethylene can be decomposed and discharged with tail gas.

In some embodiments, when feeding ammonia gas into the PECVD deposition chamber, and turning on a radio frequency power supply to ionize hydrogen ions from the ammonia gas, the preparation method includes:
S61, feeding 8000sccm to 11000sccm of ammonia and 3000sccm to 6000sccm of nitrous oxide into the PECVD chamber with a RF power of 15000KW to 18000KW.

When the RF power is 15000KW to 18000KW, the ammonia gas feeding into the PECVD chamber will ionize hydrogen ions, and nitrous oxide will ionize oxygen atoms. The free hydrogen ions can bond with the oxygen atoms in nitrous oxide to form hydroxyls, and the hydroxyls can bond with aluminum ions to improve the passivation effect of the alumina layer 3. The flow rate of ammonia gas can be 8000sccm, 10000sccm, or 11000sccm, etc., and the flow rate of nitrous oxide can be 3000sccm, 4500sccm, or 6000sccm, etc., so that more hydrogen ions are ionized by ammonia gas, in which a part of hydrogen ions bonds with oxygen in nitrous oxide, another part of hydrogen ions can be diffused to the aluminum-silicon layer 2 and the alumina layer 3.

As shown in FIG. 6, when diffusing the hydrogen ions to the aluminum-silicon layer 2, the preparation method includes:
S71, increasing temperature within the PECVD chamber to 500°C to 600°C;
S72, depositing a silicon oxide layer 6 and a silicon oxide layer 7.

When the temperature of PECVD chamber is increased to 500°C to 600°C for 2min to 5min, the activity of hydrogen ions can be improved, so that hydrogen ions can pass through the silicon nitride film and diffuse to the aluminum-silicon layer 2 and the alumina interface. Due to iconicity of the aluminum-silicon layer 2, the aluminum-silicon bonds will form positive and negative charge centers through electron transfer. In the heating process, free electron-hole pairs are generated to form aluminum-hydrogen bonds, so that silicon-hydrogen bonds at the conventional interface can be replaced, and thus reducing chemical passivation loss. Other ions ionized by ammonia gas and nitrous oxide are discharged with tail gas.

Under the environment of 500°C to 600°C, silane, ammonia gas and nitrous oxide are fed into the PECVD chamber to facilitate the deposition of the nitrous oxide layer 6 on the first surface, which can reduce the surface state density, inhibit the carrier recombination, thereby improving the open circuit voltage, and further reducing sunlight reflection of the photovoltaic cell to increase sunlight absorption, and then improving the short circuit current. Then, silane and nitrous oxide are fed into the PECVD deposition cavity to facilitate the deposition of the silicon oxide layer 7 on the first surface, thereby improving the passivation effect of the first surface.

In some embodiments, when feeding ammonia gas into the PECVD deposition chamber, and turning on a radio frequency power supply to ionize hydrogen ions from the ammonia gas, the preparation method includes:
S62, cooling the PECVD chamber to 300°C to 400°C, feeding ammonia gas with a flow rate of 8000 sccm to 15000 sccm, and RF power of 10,000 KW to 18,000 KW to produce free hydrogen ions.

The RF power can be 10000KW, 15000KW, 18000KW, so that ammonia gas absorbs energy in the high RF electromagnetic field to decompose into hydrogen ions and nitrogen atoms, in which free hydrogen ions are used to diffuse to the aluminum-silicon layer 2, and nitrogen atoms can be discharged with the exhaust gas in the PECVD deposition chamber. When the silicon nitride layer 5 is deposited, the temperature within the PECVD chamber is 450°C to 520°C, and the temperature within the PECVD chamber is reduced to 300°C to 400°C, which reduces the activity of hydrogen ions ionized from ammonia gas. If the temperature within the PECVD chamber is higher than 400°C, hydrogen ions are too active, and the bonding effect with the surface of the aluminum-silicon layer 2 is poor, resulting in poor anti-ultraviolet effect of the photovoltaic cells.

When diffusing the hydrogen ions into the aluminum-silicon layer 2, the preparation method includes:
S73, turning on an infrared lamp in the PECVD chamber to irradiating for 5min to 10min.

The activity of hydrogen ions was increased by infrared rays, and hydrogen ions were injected into the aluminum-silicon layer 2. Under the stimulation of infrared rays, the aluminum-silicon bonds will form positive and negative charge centers through electron transfer to generate free electron-hole pairs, which bond with hydrogen ions to form aluminum-hydrogen bonds. The chemical passivation loss of photovoltaic cells is reduced under irradiation of ultraviolet light.

As shown in FIG. 7 and FIG. 8, after diffusing hydrogen ions to the aluminum-silicon layer 2, the preparation method includes:
S8, depositing the passivation layer 8 on the second surface of the substrate 1 by PECVD;
S9, printing the electrode line 9 on the first surface and second surface of the substrate 1 by screen printing.

The passivation layer 8 is deposited on the phosphorus-doping layer 16 on the second surface of the substrate 1 to improve the passivation effect of the second surface to improve the conversion efficiency of the photovoltaic cell.

The present disclosure relates to a photovoltaic cell preparation method, and a photovoltaic cell. The method includes: preparing a substrate 1 including a first surface and a second surface opposite to each other, wherein the first surface is a textured structure; placing the substrate 1 into an ALD deposition chamber; sequentially depositing an aluminum-silicon layer 2 and an alumina layer 3 on the first surface; placing the substrate 1 having the aluminum-silicon layer 2 and the alumina layer 3 into a PECVD deposition chamber; depositing a silicon nitride layer 5 on the alumina layer 3; feeding ammonia gas into the PECVD deposition chamber, and turning on a radio frequency power supply to ionize hydrogen ions from the ammonia gas; and diffusing the hydrogen ions into the aluminum-silicon layer 2. The aluminum-silicon layer 2 forms an aluminum-silicon bond on the first surface of the substrate, hydrogen ions are diffused to the aluminum-silicon layer 2 to form an aluminum-hydrogen bond. When ultraviolet light is irradiated to the surface of the photovoltaic cell, the aluminum-hydrogen bond can reduce the possibility of damage caused by ultraviolet light to the silicon-hydrogen bond on the surface of the silicon layer, so that the chemical passivation loss of the photovoltaic cell is reduced, thereby improving the conversion efficiency.

## Claims

1. A photovoltaic cell preparation method, comprising:
preparing a substrate comprising a first surface and a second surface opposite to each other, wherein the first surface has a textured structure;
placing the substrate into an Atomic Layer Deposition (ALD) chamber;
sequentially depositing an aluminum-silicon layer and an alumina layer on the first surface;
placing the substrate having the aluminum-silicon layer and the alumina layer into a Plasma Enhanced Chemical Vapor Deposition (PECVD) chamber;
depositing a silicon nitride layer on the alumina layer;
feeding ammonia gas into the PECVD chamber, and turning on a radio frequency power supply to ionize hydrogen ions from the ammonia gas; and
diffusing the hydrogen ions into the aluminum-silicon layer.

2. The photovoltaic cell preparation method according to claim 1, further comprising during the sequentially depositing an aluminum-silicon layer and an alumina layer on the first surface,
feeding 16 sccm to 20 sccm of Trimethyl aluminum (TMA) into the ALD chamber for 7 s to 9 s; and then feeding nitrogen gas to purge for 10 s to 14 s, and cycling for 7 times to 12 times, in order to deposit the aluminum-silicon layer.

3. The photovoltaic cell preparation method according to claim 2, further comprising after the feeding 16 sccm to 20 sccm of Trimethyl aluminum (TMA) into the ALD chamber for 7 s to 9 s,
feeding nitrogen gas to purge for 10 s to 14 s.

4. The photovoltaic cell preparation method according to claim 3, further comprising after the feeding nitrogen gas to purge for 10 s to 14 s,
feeding 20 sccm to 24 sccm of water vapor for 4 s to 6 s.

5. The photovoltaic cell preparation method according to claim 4, further comprising
before the feeding 16 sccm to 20 sccm of Trimethyl aluminum (TMA) into the ALD chamber for 7 s to 9 s,
firstly feeding 18 sccm to 22 sccm of water vapor into the ALD chamber for 4 s to 6 s, and then feeding nitrogen gas to purge for 10 s to 14 s, and cycling for 3 times to 7 times.

6. The photovoltaic cell preparation method according to claim 2, further comprising after depositing the aluminum-silicon layer,
processes including the feeding 16 sccm to 20 sccm of Trimethyl aluminum (TMA), the feeding nitrogen gas to purge for 10 s to 14 s, the feeding 20 sccm to 24 sccm of water vapor, and processes as described in claim 5 are cycled for 8-12 times, so that a dense aluminum-silicon layer 2 of 0.5 nm to 1 nm is formed on the textured structure of the first surface.

7. The photovoltaic cell preparation method according to any one of claims 1-6, wherein the first surface of the substrate comprises a first region and a second region, the first region is configured to be provided with an electrode line;
the preparation method further comprises coating a separating layer in the first region, and curing before placing the substrate into the ALD chamber.

8. The photovoltaic cell preparation method according to claim 3, the separating layer is a polytetrafluoroethylene coating.

9. The photovoltaic cell preparation method according to claim 1, further comprising:
increasing the temperature within the PECVD chamber from 460 °C to 550 °C for 15 min to 25 min after placing the substrate having the aluminum-silicon layer and the alumina layer into the PECVD chamber.

10. The photovoltaic cell preparation method according to claim 9, further comprising
feeding 8000 sccm to 11000 sccm of ammonia gas and 3000 sccm to 6000 sccm of nitrous oxide into the PECVD chamber with a RF power of 15000 KW to 18000 KW during the feeding ammonia gas into the PECVD chamber, and turning on a radio frequency power supply to ionize hydrogen ions from the ammonia gas.

11. The photovoltaic cell preparation method according to claim 1, further comprising during the diffusing the hydrogen ions into the aluminum-silicon layer,
increasing temperature within the PECVD chamber to 500°C to 600°C; and
depositing a silicon nitride layer and a silicon oxide layer.

12. The photovoltaic cell preparation method according to claim 6, further comprising
cooling the PECVD chamber to 300°C to 400°C, feeding ammonia gas with a flow rate of 8000 sccm to 15000 sccm, and RF power of 10,000 KW to 18,000 KW to produce free hydrogen ions during the feeding ammonia gas into the PECVD chamber, and turning on a radio frequency power supply to ionize hydrogen ions from the ammonia gas.

13. The photovoltaic cell preparation method according to any one of claims 10-12, further comprising
turning on an infrared lamp in the PECVD chamber to irradiating for 5min to 10min during the diffusing the hydrogen ions into the aluminum-silicon layer.

14. A photovoltaic cell, comprising:
a substrate comprising a first surface and a second surface opposite to each other, wherein the first surface is provided with a boron doping layer;
wherein an aluminum-silicon layer, an alumina layer, and a silicon nitride layer are arranged on a surface of the boron doping layer in sequence by the photovoltaic cell preparation method as claimed in any one of claims 1 to 13.

15. The photovoltaic cell according to claim 14, wherein a thickness of the aluminum-silicon layer ranges from 0.5 nm to 1 nm.

## Amended claims

### Amended claims in accordance with Rule 137(2) EPC.

1. A photovoltaic cell preparation method, **characterized by** comprising: preparing a substrate (1) comprising a first surface and a second surface opposite to each other, wherein the first surface has a textured structure; placing the substrate (1) into an Atomic Layer Deposition (ALD) chamber;
sequentially forming an aluminum-silicon layer (2) and depositing an alumina layer (3) on the first surface by ALD, wherein the substrate is an silicon substrate, and the aluminum-silicon layer (2) is formed by reacting Trimethyl aluminum and silicon on a surface of the silicon substrate;
placing the substrate (1) having the aluminum-silicon layer (2) and the alumina layer (3) into a Plasma Enhanced Chemical Vapor Deposition (PECVD) chamber;depositing a silicon nitride layer (5) on the alumina layer (3) by PECVD;
feeding ammonia gas into the PECVD chamber, and turning on a radio frequency power supply to ionize hydrogen ions from the ammonia gas; and
diffusing the hydrogen ions into the aluminum-silicon layer (2).

2. The photovoltaic cell preparation method according to claim 1, further comprising during the sequentially depositing an aluminum-silicon layer (2) and an alumina layer (3) on the first surface, feeding 16 sccm to 20 sccm of Trimethyl aluminum (TMA) into the ALD chamber for 7 s to 9 s; and then feeding nitrogen gas to purge for 10 s to 14 s, and cycling for 7 times to 12 times, in order to deposit the aluminum-silicon layer (2).

3. The photovoltaic cell preparation method according to claim 2, further comprising after the feeding nitrogen gas to purge for 10 s to 14 s,
feeding 20 sccm to 24 sccm of water vapor for 4 s to 6 s.

4. The photovoltaic cell preparation method according to claim 3, further comprising
before the feeding 16 sccm to 20 sccm of Trimethyl aluminum (TMA) into the ALD chamber for 7 s to 9 s,
firstly feeding 18 sccm to 22 sccm of water vapor into the ALD chamber for 4 s to 6 s, and then feeding nitrogen gas to purge for 10 s to 14 s, and cycling for 3 times to 7 times.

5. The photovoltaic cell preparation method according to any one of claims 1-4, wherein the first surface of the substrate (1) comprises a first region and a second region, the first region is configured to be provided with an electrode line (9);
the preparation method further comprises coating a separating layer (4) in the first region, and curing before placing the substrate (1) into the ALD chamber.

6. The photovoltaic cell preparation method according to claim 5, the separating layer (4) is a polytetrafluoroethylene coating.

7. The photovoltaic cell preparation method according to claim 1, further comprising:
increasing the temperature within the PECVD chamber to 460 °C to 550 °C for 15 min to 25 min after placing the substrate (1) having the aluminum-silicon layer (2) and the alumina layer (3) into the PECVD chamber.

8. The photovoltaic cell preparation method according to claim 1, further comprising during the diffusing the hydrogen ions into the aluminum-silicon layer (2),
increasing temperature within the PECVD chamber to 500°C to 600°C; and
depositing a silicon nitride layer (5) and a silicon oxide layer (7).

9. The photovoltaic cell preparation method according to claim 8, further comprising turning on an infrared lamp in the PECVD chamber to irradiating for 5min to 10min during the diffusing the hydrogen ions into the aluminum-silicon layer (2).

10. A photovoltaic cell, comprising:
a substrate (1) comprising a first surface and a second surface opposite to each other, wherein the first surface is provided with a boron doping layer (12);
wherein an aluminum-silicon layer (2), an alumina layer (3), and a silicon nitride layer (5) are arranged on a surface of the boron doping layer (12) in sequence by the photovoltaic cell preparation method as claimed in any one of claims 1 to 9.

11. The photovoltaic cell according to claim 10, wherein a thickness of the aluminum-silicon layer (2) ranges from 0.5 nm to 1 nm.
